# EUROPÄISCHE PATENTSCHRIFT

(11) **EP 0 963 143 B1**
(45) Veröffentlichungstag und Bekanntmachung des Hinweises auf die Patenterteilung: **26.03.2003**
(21) Anmeldenummer: 99110628.7
(22) Anmeldetag: 02.06.1999
(51) Int. Cl.: H05K 3/32

(54) **Keramischer Träger mit einer elektrischen Schaltung und mit einer Anschlussvorrichtung**
Ceramic substrate with electrical circuit and with connecting means
Substrat céramique portant un circuit électrique et des moyens pour connecter

(30) Priorität: 06.06.1998 DE 19825451
(43) Veröffentlichungstag der Anmeldung: 08.12.1999
(73) Patentinhaber: E.G.O. ELEKTRO-GERÄTEBAU GmbH, 75038 Oberderdingen (DE)
(72) Erfinder: Paul, Reinhold, 68219 Mannheim (DE); Bierbaum, Achim, 74078 Heilbronn (DE)
(74) Vertreter: Patentanwälte Ruff, Wilhelm, Beier, Dauster & Partner

(56) Entgegenhaltungen:
- US-A- 3 421 937
- US-A- 4 215 235
- US-A- 4 542 438
- US-A- 4 960 978

## Beschreibung

Die Erfindung betrifft einen keramischen Träger mit einer elektrischen Schaltung und mit einer Anschlussvorrichtung nach dem Oberbegriff des Anspruchs 1. insbesondere ist die elektrische Schaltung direkt auf dem Träger angeordnet bzw. darauf aufgebracht.

Keramische Träger dieser Art, die beispielsweise in Dickschichttechnik aufgebrachte Schaltungen und/oder Leiterbahnen aufweisen, sind bekannt. Befestigt werden die meist flächig ausgeführten Träger durch Schraubverbindungen, die durch Ausnehmungen in dem Träger hindurchgeführt sind, oder aber mittels Einklemmen bzw. Arretieren am Randbereich oder den Kanten bzw. Ecken des Trägers. Der elektrische Anschluß für die Schaltung wird in aller Regel mit Kabeln durchgeführt, die auf Anschtußfelder der Schaltung aufgeschweißt und nachträglich durch Klebstoff o. dgl. gesichert werden, siehe beispielsweise DE 195 41 976.

Dabei ist die mechanische Befestigung aufwendig und aufgrund der Materialeigenschaften von Keramik einer hohen Bruchgefahr ausgesetzt. Verkleben ist umständlich und macht ein nachträgliches Auswechseln von Baugruppen bzw. Trägern kompliziert und beinahe unmöglich.

Aus der US-PS 4,215,235 ist es bekannt, einen stufenförmigen, zylindrischen Anschluss aus Metall mit leitenden Schichten auf einem Keramikträger zu verbinden. Die leitenden Schichten bestehen dabei aus einer Leiterbahn, einer Lötzinnschicht sowie einer Dickschicht-Schaltung auf dem Keramikträger. Der Anschluss ragt mit einem Zapfen in Ausnehmungen in den Schichten und ist mit einer weiteren Lötzinnschicht mit diesen verlötet.

### AUFGABE UND LÖSUNG

Es ist Aufgabe der Erfindung, einen keramischen Träger mit einer elektrischen Schaltung und einer Anschlußvorrichtung zu schaffen, der die Nachteile des Standes der Technik vermeidet, mit geringem Aufwand herstellbar, montierbar und austauschbar ist sowie zuverlässig an weitere Vorrichtungen angeschlossen werden kann.

Diese Aufgabe wird erfindungsgemäß durch die Merkmale des Anspruchs 1 gelöst. Ein metallischer Anschluß der Anschlußvorrichtung ist vielseitig verwendbar, u.a, zum Anschweißen von Kontaktleitungen oder für Schraub- oder Klemmverbindungen. Die Verbindung mit metallhaltigen und leichter verformbaren Ausgleichsmitteln kann eine günstige Anbindung an den Träger selber ermöglichen, vor allem über Verlöten. Unter Verformbarkeit soll hier entweder plastische Verformbarkeit verstanden werden. Es ist möglich, die Ausgleichsmittel zusätzlich oder alternativ elastisch verformbar auszuführen, entweder durch Materialwahl oder Formgestaltung. Auf diese Weise lassen sich Schwierigkeiten bei der Verbindung durch Löten zwischen einem metallischen Anschluß und der Keramik beseitigen, die durch unterschiedliches Materialverhalten beim Abkühlen nach dem Löten auftreten können. Unter einem keramischen Träger soll auch ein Träger beliebiger Art mit keramischer Oberfläche einbezogen sein.

Bei einer bevorzugten Ausgestaltung können die Ausgleichsmittel im Bereich zwischen Anschluß und Träger angeordnet sein, evtl. auch den Anschluß teilweise umgebend. Sie sind aus dünnem Material oder Flachmaterial gefertigt, wobei sie vorzugsweise als flache Scheibe ausgebildet sind. Bei einer besonders bevorzugten Ausgestaltung weisen die Ausgleichsmittel eine Ausnehmung auf, günstigerweise in einem Zentralbereich, und sind insbesondere als Flansch bzw. als Ringscheibe ausgebildet. Durch die Ausnehmung kann eine zusätzliche Elastizität bzw. Verformbarkeit des Materials in Richtung auf die Ausnehmung zu gegeben sein, so ist ein verbesserter Ausgleich unterschiedlicher Materialausdehnungen in der Keramik und einem Anschluß möglich.

Bei einer Ausbildung der Ausgleichsmittel als Flansch bzw. Ringscheibe können diese den Anschluß weit überragen und eine Materialstärke in radialer Richtung in einem Bereich zwischen 0,2 mm und 4 mm aufweisen, vorzugsweise 0,4 mm bis 2 mm, wobei beispielsweise ca. 0,5 mm oder 1 mm besonders geeignet sein können. Die Höhe kann in einem Bereich zwischen 0,2 mm und 10 mm liegen, insbesondere bei etwa 2 mm.

Zur Erzielung einer geeigneten Verformbarkeit können die Ausgleichsmittel kupferhaltig sein und zumindest abschnittsweise, bevorzugt im wesentlichen, aus Kupfer bestehen. Weitere Materialien, insbesondere bei einer Fertigung des Anschlusses aus Stahl, können Nickel, Molybdän, Wolfram, Aluminium oder Kombinationen davon sein. Verformbare Ausgleichsmittel können als Zwischenschichten zwischen Anschluß und Träger ausgebildet sein, wobei sie direkt oder mittels weiterer Verbindungsmittel an den Träger angebunden sein können.

Die Verbindung von Ausgleichsmittel und Träger, insbesondere auch von Ausgleichsmittel und Anschluß, wird durch Löten, bevorzugt durch Aktivlöten, mit einer Lotschicht hergestellt. Das Aktivlot weist vorzugsweise eine Basis aus Silber und/oder Kupfer mit einer reaktiven Legierungskomponente auf, die eine hohe Sauerstoffaffinität und/oder Stickstoffaffinität besitzt. Dazu eignen sich besonders bevorzugt Titan oder ein Selten-Erd-Metall, des weiteren Lote auf einer Nickelbasis. Gelötet werden kann bei Temperaturen über 730°C, bevorzugt bei etwa 850°C. Die Benetzung und Bindung auf der Keramik wird durch den Legierungszusatz mit hoher Sauerstoff- oder Stickstoffaffinität erreicht, während die Bestandteile des Basislots die Verbindung zu dem metallischen Anschluß herstellen. Eine weitere Möglichkeit sieht vor, Anschluß und Ausgleichsmittel beispielsweise zu verschweißen. Eine weitere Befestigungsmöglichkeit neben Einbrennen oder Löten in einem Ofen ist Ultraschallschweißen.

Das Aktivlot, das in Pasten- oder in Folienform vorliegen kann, kann in einem zu den Ausgleichsmitteln bzw. dem Anschluß korrespondierenden oder diese überragenden Flächenbereich, insbesondere direkt, auf den Träger aufgebracht sein und so mit einer, bevorzugt zwei, Schichten den Anschluß mit dem Träger verbinden. Ein Aktivlot auf überwiegend metallischer Basis, bevorzugt rein metallisch, ermöglicht in vorteilhafter Weise die elektrische Anbindung der Schaltung auf dem Träger an den Anschluß. Durch relativ dünne Lotschichten können Übergangswiderstände gering gehalten werden.

Bei einer bevorzugten Ausgestaltung der Erfindung ist der Anschluß sowohl für eine mechanische Anbindung oder Befestigung des Trägers als auch eine elektrische Verbindung der Schaltung ausgebildet. Für eine mechanische Anbindung kann er ein Gewinde, einen Rast- oder Klemmanschluß o. dgl. aufweisen, insbesondere zur Befestigung weiterer Vorrichtungen an dem Träger oder zur Befestigung des Trägers. Der Anschluß kann länglich bzw. zylindrisch ausgeführt sein. Bevorzugt weist er einen Basisabschnitt mit vergrößertem Querschnitt auf, beispielsweise nach Art eines Fußes oder einer Grundplatte, mit einer den Ausgleichsmitteln entsprechenden Form. Auf diese Weise kann ein Schichtaufbau hergestellt werden, der aus Träger, Lotschicht, Ausgleichsmitteln, Lotschicht, Basisabschnitt und Anschluß besteht.

Bei einer alternativen Ausgestaltung können Ausgleichsmittel in Form einer Scheibe, evtl. als Lochscheibe, direkt mit dem Anschluß verbunden sein, beispielsweise durch Schweißen oder Löten bzw. Aktivlöten. So ist ein einfacherer Aufbau möglich.

Die hohe Verformbarkeit der Ausgleichsmittel im Vergleich zu dem Anschluß ermöglicht eine weitgehende Reduzierung bzw. Vermeidung der bei Erstarrung der Lote auftretenden mechanischen Spannungen der Grundwerkstoffkombination Keramik/Metall. Die elastische oder plastische Verformung des Lotes wird um die zusätzliche Verformungsmöglichkeit der Ausgleichsmittel aufgrund deren Verformbarkeit zusätzlich erweitert. Die Verformbarkeit der Ausgleichsmittel kann durch eine geeignete Materialauswahl, bevorzugt Kupfer, und/oder durch besondere geometrische Gestaltung weiter erhöht werden. Bei geringen Spannungen werden sich die Ausgleichsmittel elastisch verformen, bei erheblichen Spannungen eher plastisch verformen.

Nach dem Lötvorgang erhält man einen keramischen Träger mit einem metallischen Anschluß, deren Verbindung, insbesondere weit unterhalb der Bruchspannung der Keramik, spannungsreduziert ist und die dennoch mechanisch hoch belastbar ist. Durch ein Löten direkt auf die Keramik ist die Gefahr eines Abreißens von Zwischenschichten vermieden, ein Aktivlot stellt die Anbindung an die Keramik sicher.

Bei einer Ausführung der Erfindung verlaufen Aktivlot und ein Anschlußfeld der Schaltung in einem Bereich mit geringem Abstand zueinander und bilden, durch eine Trennfuge getrennt, eine Kontaktzone. Die Kontaktzone kann mit einer die beiden Schichten überlappenden und die Trennfuge füllenden Kontaktschicht versehen sein, welche elektrisch leitfähig und vorzugsweise eine Leitpaste mit einer unter dem Schmelzpunkt des Aktivlots liegenden Einbrenntemperatur, beispielsweise ca. 650° C, sein kann. Dazu kann das Aktivlot einen den Verbindungsbereich zu dem Anschluß abzweigende Fläche bilden. Zur Reduzierung des Übergangswiderstandes durch vergrößerte Kontaktfläche kann die Trennfuge verlängert beispielsweise zick-zack-förmig, wellenartig o. dgl. ausgebildet sein. Alternativ können Aktivlot und Anschlußfeld direkt überlappend ausgeführt sein, wobei vorzugsweise zuerst das Aktivlot und anschließend die Leitpaste des Anschlußfeldes aufgebracht bzw. eingebrannt wird.

Die Höhe der Aktivlotschichten bzw. Höhe der Lotspalte zwischen Ausgleichsmitteln und Träger und/oder Anschluß liegt vorzugsweise zwischen 0,01 mm und 4 mm, insbesondere zwischen 0,2 mm und 2 mm, wobei eine Höhe von ca. 1 mm als besonders vorteilhaft angesehen wird. Dadurch können mögliche Unebenheiten zu verlötender Flächen ausgeglichen werden.

Zwischen den Ausgleichsmitteln und dem Träger können eine Anpassungsplatte, Anpassungsringscheibe o.dgl. vorgesehen sein, die vorzugsweise flach und planparallel sein können. Sie sind vorteilhaft durch ein Aktivlot benetzbar und bestehen in diesem Fall aus Metall oder Keramik. Ein Metall kann ähnlich wie das der Ausgleichsmittel sein, etwa Kupfer, eine Keramik ähnlich wie das Material des Trägers sein.

Die elektrische Schaltung weist bevorzugt eine Heizungseinrichtung auf, insbesondere eine Dickschichtwiderstandsheizung. Sie kann aus einer flächig auf den Träger aufgebrachten und eingebrannten Widerstandspaste bestehen. Eine elektrische Kontaktierung kann über wenigstens ein Anschlußfeld o. dgl. der Heizungseinrichtung erfolgen, das vorzugsweise von der Heizfunktion ausgenommen ist. Es ist möglich, mehrere voneinander getrennte elektrische Schaltungen auf dem Träger anzuordnen. Alternativ ist es möglich, eine Heizungseinrichtung bzw. Widerstandsheizung zumindest teilweise, insbesondere vollständig, aus einer Aktivlotschicht aufzubauen. Auf diese Weise kann eine Kontaktierung von dem Aktivlot an die Schaltung bzw. Heizungseinrichtung eingespart werden.

Eine Anwendung der Erfindung sieht einen keramischen Träger vor, der als scheibenförmige Keramikkochplatte mit ebener Vorderseite zum Einsatz in einem Elektroherd ausgebildet ist, wobei Anschlußvorrichtungen und Dickschichtwiderstandsheizung auf seiner Rückseite angeordnet sind. Die Kochplatte ist mittels mehrerer Anschlußvorrichtungen sowohl elektrisch mit der Herdsteuerung verbunden als auch mechanisch befestigt. Des weiteren können an der Anschlußvorrichtung weitere Vorrichtungen, wie beispielsweise Temperaturbegrenzer o. dgl. vorgesehen sein.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNGEN

Mehrere Ausführungsbeispiele der Erfindung sind in den Zeichnungen dargestellt und werden im folgenden näher erläutert. In den Zeichnungen zeigen:
- Fig. 1: einen Querschnitt durch einen erfindungsgemäßen keramischen Träger, auf den mittels einer Aktivlotschicht eine Ringscheibe als Ausgleichsmittel und eine Grundplatte mit einem Gewindebolzen angebracht sind,
- Fig. 2: eine Vorrichtung gemäß Fig. 1, bei der zwischen Träger und Ringscheibe eine Keramikscheibe angeordnet ist,
- Fig. 3: eine Vorrichtung ähnlich wie Fig. 2, bei der Gewindebolzen und Grundplatte einstückig sind und anstelle der Keramikscheibe eine zusätzliche Ringscheibe vorgegeben ist,
- Fig. 4: eine vergrößerte Detailansicht der Aktivlotschichten, eines Teils der Heizungseinrichtung sowie der Kontaktzone zwischen den beiden mit einer zick-zack-förmigen Trennfuge,
- Fig. 5: Ansicht der Rückseite eines als Kochplatte ausgebildeten Trägers mit drei Anschlüssen im Randbereich und
- Fig. 6: Seitenansicht der Kochplatte aus Fig. 5, mit einem an den Anschlußbolzen angeschweißten Anschlußdraht.

### BESCHREIBUNG DER AUSFÜHRUNGSBEISPIELE

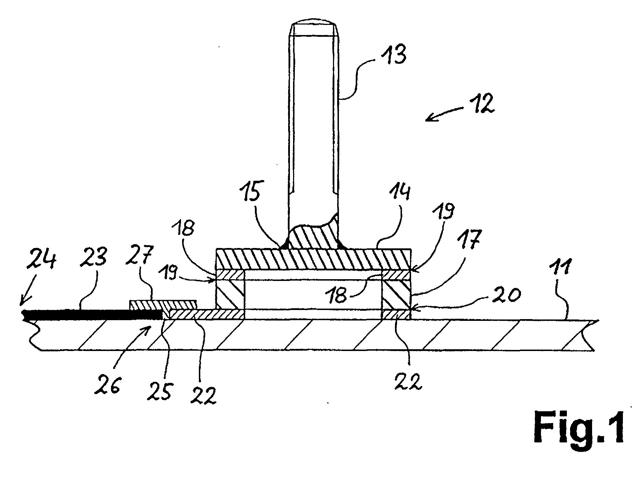

Die Fig. 1 zeigt im Teilschnitt einen erfindungsgemäßen keramischen Träger 11, auf dem eine Anschlußvorrichtung 12 angebracht ist. Die Keramik des Trägers 11 kann eine für Dickschichttechnik geeignete Keramik sein, beispielsweise Siliciumnitrid. Die Anschlußvorrichtung 12 besteht aus einem Gewindebolzen 13, der mit einem Ende mit einer Grundplatte 14 verbunden ist, in der Fig. 1 durch Schweißen in der Kehlnaht 15 entlang dem Außendurchmesser des Bolzens 13. Andere Verbindungsmöglichkeiten sind beispielsweise Kontaktschweißen oder Lötverfahren. Die Dicke der Grundplatte kann in etwa in der Größenordnung derjenigen der Ausgleichsmittel liegen. Die rundscheibenförmige Grundplatte 14 ist mit einer Ringscheibe 17 als Ausgleichsmittel verbunden, und zwar durch Aktivlot 18 in dem Lotspalt 19 zwischen Grundplatte und Ringscheibe. Die Ringscheibe 17 wiederum ist über eine untere Aktivlotschicht 22 in einem zweiten Lotspalt 20 mit dem Träger 11 verbunden. Die Höhe der Lotspalte 19 und 20 beträgt in dieser Zeichnung etwa die Hälfte der Dicke der Grundplatte 14 und etwa ein Drittel der Höhe der Ringscheibe 17. Andere Dimensionierungen der Lotspalte 19 und 20, evtl. unterschiedlich bzw. nicht kontinuierlich, sind bei der Anwendung der Erfindung in einem weiten Bereich möglich. Die Zeichnungen sollen im wesentlichen den prinzipiellen (Schicht-)Aufbau wiedergeben.

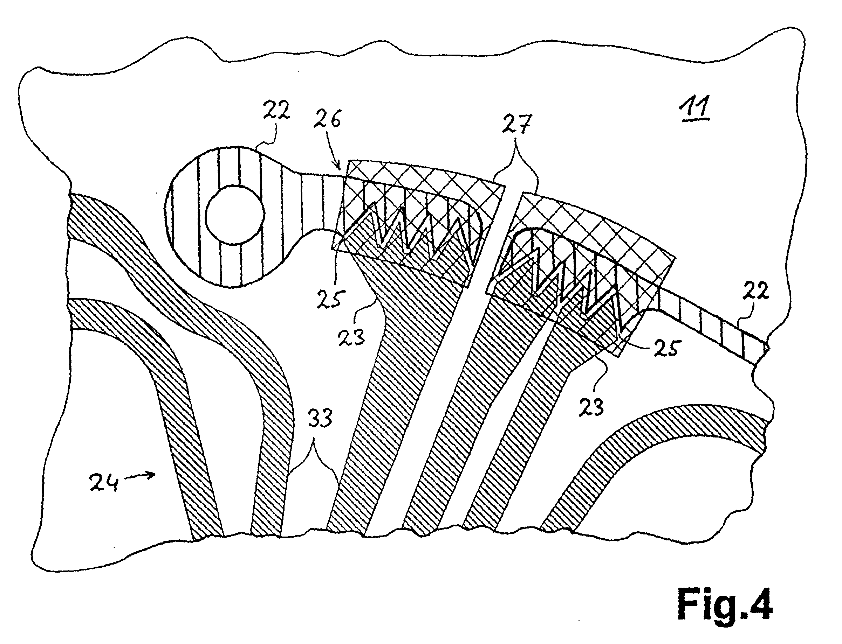

Die untere Aktivlotschicht 22 auf dem Träger 11 setzt sich in der Fig. 1 nach links weit über den Bereich der Ringscheibe 17 fort in Richtung zu einem Anschlußfeld 23 einer elektrischen Schaltung 24, die ebenfalls als Schicht auf dem Träger ausgeführt ist. Getrennt sind die Aktivlotschicht 22 und das Anschlußfeld 23 durch eine Trennfuge 25. Die Trennfuge 25 kann eine Weite im Bereich von 0,05 mm bis 2 mm aufweisen, vorzugsweise etwa 0,1 mm bis 0,2 mm. Über die Aktivlotschicht 22 und das Anschlußfeld 23 ist im Bereich einer Kontaktzone 26, an die Trennfuge 25 angrenzend, eine Kontaktschicht 27 die beiden unteren Schichten überlappend und die Trennfuge 25 ausfüllend aufgebracht. Eine detaillierte Ausgestaltungsmöglichkeit der Kontaktierung mittels Trennfuge 25 und Kontaktschicht 27 ist in Fig. 4 dargestellt und im Beschreibungstext beschrieben.

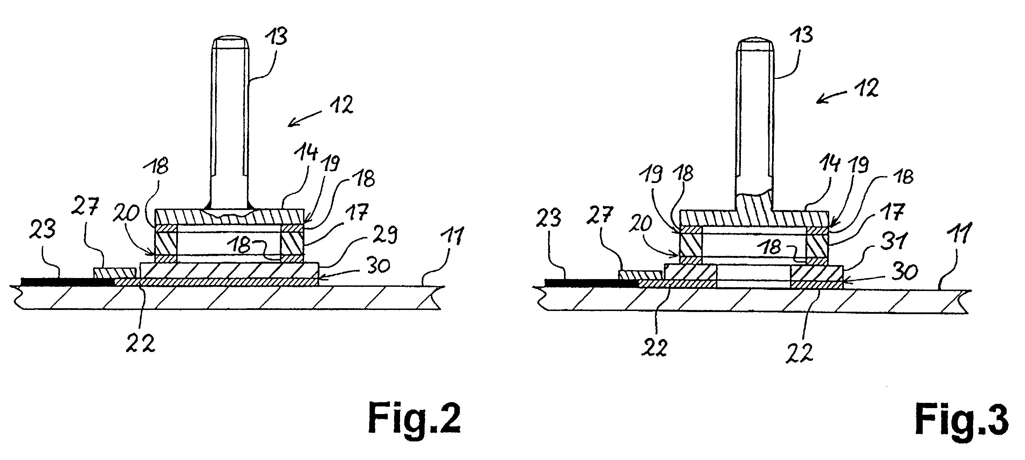

Die Fig. 2 zeigt eine Anordnung ähnlich Fig. 1. Hier besteht die Anschlußvorrichtung 12 aus Gewindebolzen 13 und Grundplatte 14 an der mittels Aktivlot in dem ersten Lotspalt 19 die Ringscheibe 17 angelötet ist. Die Ringscheibe 17 ist über den zweiten Lotspalt 20 mit einer keramischen Anpassungsplatte 29 verlötet, die quasi den Träger 11 in Fig. 1 ersetzt bzw. zusätzlich vorhanden ist. Die Anpassungsplatte kann alternativ aus Metall bestehen, bevorzugt aus einem Material ähnlich der Ringscheibe, vorteilhaft aus Kupfer. In diesem Fall kann die Verbindung zwischen Ringscheibe und Anpassungsplatte durch übliches Löten oder Schweißen erfolgen. Die Anpassungsplatte 29 ist mittels Aktivlöten im Bereich eines dritten Lotspaltes 30 mit dem Träger 11 verbunden. Bei dieser Ausführung können die Ausgleichsmittel im wesentlichen durch das Zusammenwirken von Ringscheibe 17 und Anpassungsplatte 29 gebildet werden. Bei einer rein mechanisch ausgelegten Verbindung kann die Anpassungsplatte aus Keramik bestehen. Für eine elektrische Verbindung kann eine der oberen Aktivlotschichten die Anpassungsplatte überlappen und auf den Träger zu dem Anschlußfeld führen. Ähnlich wie in Fig. 1 ist die untere Aktivlotschicht 22 über eine aufgesetzte Kontaktschicht 27 mit einem Anschlußfeld 23 einer nicht dargestellten elektrischen Schaltung verbunden. Eine Trennfuge ist hier nicht dargestellt, kann jedoch vorteilhaft vorhanden sein.

Gewindebolzen 13 und Grundplatte 14 können bevorzugt als vorgefertigte Baueinheit, evtl. einstückig wie in Fig. 3, mit der Ringscheibe 17 und dem keramischen Träger 11 bzw. einer weiteren Anpassungsplatte 29 in einem Arbeitsgang verbunden werden. Alternativ können Gewindebolzen 13, Grundplatte 14 und Ringscheibe 17, evtl. auch Anpassungsplatte 29, zu einer Baueinheit verbunden werden, bevor die Verlötung mit dem Träger 11 durchgeführt wird. Die Verbindung Anschluß mit Ringscheibe 17 an Träger 11 bzw. an Anpassungsplatte 29 und Träger 11 erfolgt vorteilhaft in einem Arbeitsschritt, da beim Abkühlen nach einem Verlöten die entstehenden Materialspannungen aufgrund unterschiedlicher Ausdehnungskoeffizienten auch zwischen Anschlußvorrichtung 12 und den Ausgleichsmitteln, Ringscheibe 17 bzw. Anpassungsplatte 29, besser abgebaut werden können.

Fig. 3 zeigt einen Aufbau ähnlich der Fig. 2, wobei hier die Anschlußvorrichtung 12 einstückig aus Gewindebolzen 13 und angeformter Grundplatte 14 besteht. Der Schichtaufbau von Aktivlotschichten, Ringscheibe 17, Anpassungselement und Träger 11 entspricht im wesentlichen Fig. 2. Als Unterschied zu Fig. 2 ist in Fig. 3 die Anpassungsplatte durch eine Anpassungsringscheibe 31 ersetzt. Die Ausbildung als Ringscheibe, evtl. zusätzlich zu einer geeigneten Materialwahl, wie oben beschrieben, ermöglicht es, daß die Anpassungsringscheibe 31 eine ähnliche Funktion wie die Ringscheibe 17 übernimmt. Durch die Ausnehmungen jeweils in der Mitte der Scheiben 17 und 31 können radiale Kräfte, die an Ober- und Unterseite angreifend in das Material laufen, besser ausgeglichen werden, da im Mittelbereich kein einem radialem Zusammenziehen entgegen wirkendes Material ist. Somit können die Ausgleichsmittel durch ihre spezielle Geometrie (Ausnehmung in der Mitte) und geeignete Materialwahl (Material leichter verformbar als das der Anschlußvorrichtung) einen Ausgleich im Ausdehnungs- bzw. vor allem im Zusammenziehverhalten zwischen Anschlußvorrichtung und keramischem Träger beim Erkalten nach einem Löten sicherstellen. Es ist möglich, die Ausgleichsmittel in Umfangsrichtung mit radial oder senkrecht verlaufenden Schlitzen oder Ausnehmungen zu versehen, die ähnlich dem Effekt eines verformbaren Materials eine bereichsweise Änderung der Form bzw. Geometrie der Ausgleichsmittel zulassen können. In weiterer Ausgestaltung einer solchen Möglichkeit können die Ausgleichsmittel im wesentlichen aus zusammenhängenden kurzen Stäben, ähnlich einem Kamm oder einer Bürste, von Anschlußvorrichtung zum keramischen Träger oder umgekehrt verlaufend ausgebildet sein.

Die Fig. 4 zeigt eine mögliche Anordnung der unteren Aktivlotschicht 22, des Anschlußfeldes 23, der Kontaktzone 26 mit Trennfuge 25 und Kontaktschicht 27 sowie Dickschichtheizwiderständen 33, die die elektrische Schaltung 24 auf dem Träger 11 darstellen. Nicht dargestellt ist in der Fig. 4 die Anschlußvorrichtung 12 sowie eine Ringscheibe 17 o.dgl. Zu erkennen ist die an eine Ringscheibe angepaßte kreisringförmige Ausgestaltung der Aktivlotschicht 22 im linken Bereich. Des weiteren ist die Zick-Zack-Form der Trennfuge 25 zwischen Aktivlotschicht 22 und Anschlußfeld 23 verdeutlicht. Über die so gebildete Kontaktzone 26 wird, vorteilhaft nach dem Einbrennen dieser beiden Schichten, die Kontaktschicht 27 aufgebracht, beispielsweise durch Siebdruck mit einer Widerstandspaste, die dabei zum großen Teil in die Trennfuge 25 eindringt und nach Einbrennen eine elektrisch leitfähige Verbindung zwischen Aktivlotschicht und Anschlußfeld herstellt.

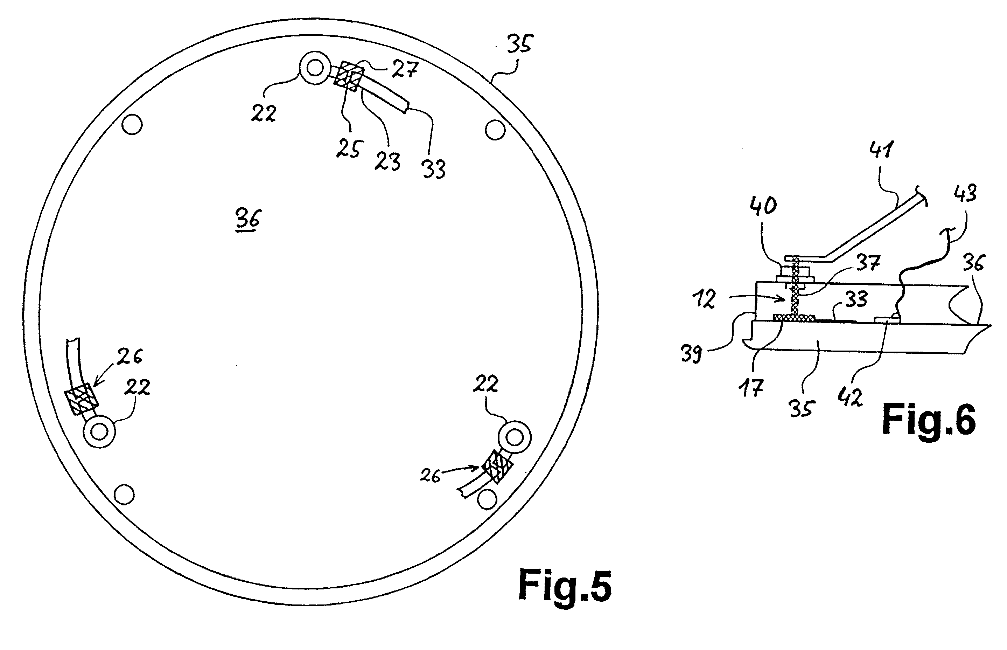

Die Fig. 5 zeigt als eine Anwendung der Erfindung eine Keramikkochplatte 35, deren Unterseite 36 dargestellt ist. Die Rückseite 36 weist drei Bereiche auf, in denen Anschlußvorrichtungen gemäß der Erfindung angebracht werden können. Ähnlich wie in Fig. 4 sind der Übersichtlichkeit halber lediglich die Aktivlotschichten 22 und Anschlußfelder 23, die in Dickschichtheizwiderstände 33 übergehen (nur teilweise) dargestellt, wobei die Trennfugen 25 mit jeweils einer Kontaktschicht 27 gefüllt und abgedeckt sind. Die Dickschichtheizwiderstände 33 können beispielsweise spiralförmig weiterlaufen und zu einem weiteren, nicht dargestellten Anschluß führen.

In Fig. 6 ist eine Seitenansicht einer Keramikkochplatte 35 gemäß Fig. 5 dargestellt, die mit ihrer Rückseite 36 nach oben weist. Auf dieser Rückseite 36 ist eine Anschlußvorrichtung 12 aufgebracht, die einen abstehenden Bolzen 37 aufweist. Des weiteren ist darauf Isoliermaterial 39 angeordnet, um die Rückseite sowie eine darauf angeordnete, mit der Anschlußvorrichtung 37 auf oben beschriebene Weise verbundene Dickschichtwiderstandsheizung 33 abzudecken. Der Bolzen 37 ragt über das Isoliermaterial 39 über, wobei er durch eine Durchführungstülle 40 geführt ist. Mit seinem Ende ist er mit einem Anschlußdraht 41 verbunden, beispielsweise durch Schweißen. Des weiteren ist an der Rückseite 36 ein Sensor 42 in direktem Kontakt mit der Keramikkochplatte 35 angeordnet, der ein aus dem Isoliermaterial 39 ragendes Sensorkabel 43 aufweist. Dieser Sensor 42 kann als Temperatursensor ausgebildet sein.

### FUNKTION

Eine Möglichkeit, einen keramischen Träger mit Merkmalen der Erfindung aufzubauen, kann folgendermaßen aussehen:

Auf die Rückseite eines keramischen Trägers 11 wird eine elektrische Schaltung 24, beispielsweise in Form von Dickschichtheizwiderständen 33, mit wenigstens einem Anschlußfeld 23 aus Widerstandspastenmaterial aufgetragen und eingebrannt. In einem nächsten Schritt wird auf ähnliche Weise die untere Aktivlotschicht 22, beispielsweise ebenfalls im Siebdruckverfahren, wie z.B. in Fig. 4 dargestellt, aufgebracht.

Eine Anschlußvorrichtung, beispielsweise bestehend aus einem Bolzen 13 mit einer Grundplatte 14, mit der er entweder einstückig ausgeführt oder vorzugsweise unlösbar verbunden ist, wird an ihrer Unterseite mit einer ringförmigen Aktivlotschicht versehen. Eine Ringscheibe 17 wird auf die Aktivlotschicht 22 auf dem Träger 11 gelegt und anschließend die Anschlußvorrichtung 12 darauf gesetzt. Danach wird der Träger zum zweitenmal durch einen Ofen gefahren, um das Aktivlot 18 zu schmelzen und die Verbindungen der Ringscheibe 17 mit der Anschlußvorrichtung bzw. der Grundplatte 14 und dem keramischen Träger 11 herzustellen, wobei sich die reaktive Legierungskomponente in dem Aktivlot mit der Keramik des Trägers 11 verbindet. Die Temperaturen bei diesem Vorgang liegen über der Schmelztemperatur des Lotes von 730°C und können bis zu 850°C betragen. Beim Abkühlen sorgt die Ringscheibe 17 aufgrund ihrer Materialeigenschaften sowie ihrer Form für einen Ausgleich des unterschiedlichen Zusammenziehens von Grundplatte 14 und keramischem Träger 11. Auf diese Weise wird eine weitgehend spannungsfreie Lötverbindung hergestellt, die mechanisch hoch belastbar und bei breiter bzw. flächiger Ausführung der Grundplatte 14 auch gegen Kippbelastung bzw. Scherkräfte widerstandsfähig ist. Es ist auch möglich, Dickschichtheizwiderstände und Aktivlöten in einem Schritt herzustellen.

Um die elektrische Kontaktierung von Anschlußvorrichtung 12 zur elektrischen Schaltung 24 bzw. Dickschichtheizwiderstände 33 herzustellen, wird abschließend eine die Kontaktzone 26 und vor allem die Trennfuge 25 abdeckende Kontaktschicht 27 in Pastenform aufgetragen und in einem dritten Ofendurchlauf bei niedrigeren Temperaturen um 650° C eingebrannt. Dabei kann eine Art Ausglühen der Spannungen in den Ausgleichsmitteln bewirkt werden. Die auftretenden Kräfte beim Abkühlen sollten sich unter der Dehngrenze des Materials der Ausgleichsmittel bewegen, damit das Material oder die Lötverbindungen nicht reißen.

## Patentansprüche

1. Keramischer Träger (11) mit einer elektrischen Schaltung (24) und mit einer Anschlußvorrichtung (12), wobei die Anschlußvorrichtung (12) mindestens einen metallischen Anschluß aufweist und der Anschluß mit metallhaltigen Ausgleichsmitteln (17) über eine Lotschicht (22) mit dem Träger verbunden ist, **dadurch gekennzeichnet, dass** die Ausgleichsmittel eine höhere plastische oder elastische Verformbarkeit als das Material des Anschlusses aufweisen zur Reduzierung bzw. Vermeidung der bei Erstarrung des Lotes (22) auftretenden mechanischen Spannungen der Grundwerkstoffkombination Keramik/Metall.

2. Keramischer Träger nach Anspruch 1, **dadurch gekennzeichnet, daß** die Ausgleichsmittel (17) zwischen dem Anschluß und der Lotschicht (22) auf dem Träger (11) angeordnet sind, wobei sie vorzugsweise aus Flachmaterial bestehen.

3. Keramischer Träger nach Anspruch 1 oder 2, **dadurch gekennzeichnet, daß** die Ausgleichsmittel wenigstens eine Ausnehmung aufweisen, vorzugsweise in einem Zentralbereich, wobei sie insbesondere als Flansch oder als Ringscheibe (17) ausgebildet sind.

4. Keramischer Träger nach Anspruch 3, **dadurch gekennzeichnet, daß** der Flansch bzw. die Ringscheibe (17) eine radiale Dicke in einem Bereich zwischen 0,2 mm und 4 mm aufweist, vorzugsweise zwischen 0,4 mm und 2 mm, wobei die Höhe in einem Bereich zwischen 0,2 mm und 10 mm, insbesondere bei ca. 2 mm, liegt.

5. Keramischer Träger nach einem der vorhergehenden Ansprüche, **dadurch gekennzeichnet, daß** die Ausgleichsmittel (17) kupferhaltig sind, wobei sie vorzugsweise zumindest abschnittsweise, insbesondere vollständig, im wesentlichen aus Kupfer bestehen.

6. Keramischer Träger nach einem der vorhergehenden Ansprüche, **dadurch gekennzeichnet, daß** die Lotschicht der Verbindung zwischen den Ausgleichsmitteln (17) und dem Träger (11), insbesondere auch zwischen den Ausgleichsmitteln und der Anschlußvorrichtung (12), eine Aktivlotschicht (22) ist, wobei insbesondere ein Aktivlot (18, 22) eine Basis aus Silber und Kupfer mit einer reaktiven Legierungskomponente mit hoher Sauerstoffaffinität und/oder hoher Stickstoffaffinität, vorzugsweise Titan und/oder ein Selten-Erd-Metall, aufweist.

7. Keramischer Träger nach Anspruch 6, **dadurch gekennzeichnet, daß** Aktivlot (18, 22) den Anschluß mit den Ausgleichsmitteln und mit dem Träger (11) verbindet und in einem zu den Ausgleichsmitteln zumindest korrespondierenden, insbesondere diese überragenden, Flächenbereich auf den Träger aufgebracht ist, wobei es vorzugsweise die elektrische Verbindung von dem Anschluß zu der elektrischen Schaltung (24) bildet.

8. Keramischer Träger nach Anspruch 6 oder 7, **dadurch gekennzeichnet, daß** die elektrische Schaltung (24) ein Anschlußfeld (23) aufweist, das in einem Bereich mit geringem Abstand zu der Aktivlotschicht (18, 22) verläuft, wobei Anschlußfeld und Aktivlotschicht durch eine Trennfuge (25) getrennt eine Kontaktzone (26) bilden, die mit einer die beiden Schichten überlappenden und die Trennfuge füllenden Kontaktschicht (27) versehen ist, welche elektrisch leitfähig ist und vorzugsweise eine Leitpaste mit einer unter dem Schmelzpunkt des Aktivlots liegenden Einbrenntemperatur ist, und wobei insbesondere die Trennfuge für maximale Länge der Kontaktierung zickzackförmig oder wellenförmig ausgebildet ist.

9. Keramischer Träger nach einem der Ansprüche 6 bis 8, **dadurch gekennzeichnet, daß** die Höhe der Aktivlotschicht (18, 22) zwischen den Ausgleichsmitteln und dem Träger und/oder zwischen dem Anschluß und den Ausgleichsmitteln in einem Bereich zwischen 0,01 mm und 4 mm liegt, vorzugsweise zwischen 0,2 mm und 2 mm.

10. Keramischer Träger nach einem der vorhergehenden Ansprüche, **dadurch gekennzeichnet, daß** zwischen den Ausgleichsmitteln und dem Träger (17) eine Anpassungsplatte (29) oder Anpassungsringscheibe (31) vorgesehen ist, wobei sie insbesondere aus einem durch ein Aktivlot (18) benetzbaren Material besteht, vorzugsweise aus Keramik oder Metall.

11. Keramischer Träger nach einem der vorhergehenden Ansprüche, **dadurch gekennzeichnet, daß** der Anschluß für eine mechanische Anbindung des Trägers (11) und eine elektrische Verbindung für die elektrische Schaltung (24) ausgebildet ist, vorzugsweise für die mechanische Anbindung mit einem Gewinde o.dgl. versehen ist, wobei er insbesondere eine Basis größeren Querschnitts zu den Ausgleichsmitteln hin aufweist.

12. Keramischer Träger nach einem der vorhergehenden Ansprüche, **dadurch gekennzeichnet, daß** er eine scheibenförmige Keramikkochplatte (35) mit ebener Vorderseite zum Einsatz in einen Elektroherd ist, wobei Anschlußvorrichtungen (12) und Dickschichtwiderstandsheizungen (33) auf der Rückseite (36) angeordnet sind, und die Kochplatte mittels mehrerer Anschlußvorrichtungen sowohl elektrisch mit der Herdsteuerung verbunden als auch mechanisch haltemd an dem Elektroherd befestigt ist.

## Revendications

1. Support céramique (11) avec un circuit électrique (24) et un moyen de connexion (12), le moyen de connexion (12) présentant au moins une borne métallique et la borne étant raccordée avec des moyens de compensation (17) métallifères par une couche de matériau d'apport de brasage (22) avec le support, **caractérisé en ce que** les moyens de compensation présentent une aptitude à la déformation plastique ou élastique plus forte que le matériau de la borne pour réduire ou encore pour éviter des tensions mécaniques qui se présentent lors de la solidification du matériau d'apport de brasage (22) par la combinaison de matériaux céramique/métal.

2. Support céramique d'après la revendication 1, **caractérisé en ce que** les moyens de compensation (17) sont disposés sur le support (11) entre la borne et la couche de matériau d'apport de brasage (22), en étant constitués de matériau plat.

3. Support céramique d'après la revendication 1 ou 2, **caractérisé en ce que** les moyens de compensation présentent au moins un creux, de préférence dans un domaine central, en étant notamment réalisés en tant que bride ou en tant que disque annulaire (17).

4. Support céramique d'après la revendication 3, **caractérisé en ce que** la bride ou encore le disque annulaire (17) présente une épaisseur radiale dans un domaine entre 0,2 mm et 4 mm, de préférence entre 0,4 mm et 2 mm, la hauteur se trouvant dans un domaine entre 0,2 mm et 10 mm, notamment auprès d'environ 2 mm.

5. Support céramique d'après une des revendications précédentes, **caractérisé en ce que** les moyens de compensation (17) sont cuivreux, en étant composés essentiellement de cuivre de préférence au moins en partie, notamment de manière intégrale.

6. Support céramique d'après une des revendications précédentes, **caractérisé en ce que** la couche de matériau d'apport de brasage de la connexion entre les moyens de compensation (17) et le support (11), notamment aussi entre les moyens de compensation et le moyen de connexion (12) est une couche de matériau de brasage actif (22), un matériau d'apport de brasage actif (18, 22) présentant notamment une base en argent et en cuivre avec un élément d'alliage réactif ayant une forte affinité par rapport à l'oxygène et/ou par rapport à l'azote, de préférence du titanium et/ou un métal des terres rares.

7. Support céramique d'après la revendication 6, **caractérisé en ce que** du matériau d'apport de brasage actif (18, 22) connecte la borne avec les moyens de compensation et avec le support (11) et qu'il est appliqué sur le support dans un domaine superficiel au moins correspondant avec les moyens de compensation et notamment saillant au-delà de ceux-ci, constituant de préférence la connexion électrique entre la borne et le circuit électrique (24).

8. Support céramique d'après la revendication 6 ou 7, **caractérisé en ce que** le circuit électrique (24) présente un champ de connexion (23), s'étendant dans un domaine à proximité de la couche de matériau d'apport de brasage actif (18, 22), le champ de connexion et la couche de matériau d'apport de brasage actif formant, en étant séparés par un joint de séparation (25), une zone de contact (26), laquelle est munie d'une couche de connexion (27) recouvrant les deux couches et remplissant le joint de séparation, laquelle conduit le courant électrique et qui est de préférence une pâte conductrice avec une température de cuite inférieure au point de fusion du matériau d'apport de brasage actif, et le joint de séparation étant notamment réalisé en forme zig-zag ou bien ondulé pour obtenir une longueur maximale de contact.

9. Support céramique d'après une des revendications de 6 à 8, **caractérisé en ce que** la hauteur de la couche de matériau d'apport de brasage actif (18, 22) entre les moyens de compensation et le support et/ou entre la borne et les moyens de compensation se trouve dans un domaine entre 0,01 mm et 4 mm, de préférence entre 0,2 mm et 2 mm.

10. Support céramique d'après une des revendications précédentes, **caractérisé en ce qu'**entre les moyens de compensation et le support (11) est prévue une plaque d'adaptation (29) ou un disque annulaire d'adaptation (31) composé notamment d'un matériau mouillable par un matériau d'apport de brasage actif (18), de préférence en céramique ou en métal.

11. Support céramique d'après une des revendications précédentes, **caractérisé en ce que** la borne est réalisée pour une jonction mécanique du support (11) et pour une connexion électrique du circuit électrique (24), en étant munie de préférence d'un filet ou similaires pour la jonction mécanique, présentant notamment du côté des moyens de compensation une base avec une section transversale relativement grande.

12. Support céramique d'après une des revendications précédentes, **caractérisé en ce qu'**il est une plaque de cuisson en céramique (35) en forme de disque avec une face antérieure plane pour l'insertion dans une cuisinière électrique, des moyens de connexion (12) et des éléments chauffants à résistance à couche épaisse (33) étant disposés à la face arrière (36), la plaque de cuisson étant non seulement branchée électriquement par plusieurs moyens de connexion avec les moyens de commande de la cuisinière, mais également branchée de manière mécanique à la cuisinière électrique en guise de support.

## Claims

1. Ceramic substrate (11) with an electrical circuit (24) and a connecting means (12), the connecting means (12) having at least one metallic connection and the connecting being connected to the substrate with metal-containing compensating means (17) via a solder layer (22), **characterized in that** the compensating means have a higher plastic or elastic deformability than the material of the connection for reducing or avoiding mechanical stresses of the base material combination ceramic/metal occurring on the solidification of the solder (22).

2. Ceramic substrate according to claim 1, **characterized in that** the compensating means (17) are located between the connection and the solder layer (22) on the substrate (11) and are preferably formed from flat material.

3. Ceramic substrate according to claim 1 or 2, **characterized in that** the compensating means have at least one recess, preferably in a central area and are in particular constructed as a flange or annular disk (17).

4. Ceramic substrate according to claim 3, **characterized in that** the flange or annular disk (17) has a radial thickness in the range 0.2 mm to 4 mm, preferably 0.4 mm to 2 mm, the height being in a range between 0.2 mm and 10 mm and is in particular approximately 2 mm.

5. Ceramic substrate according to one of the preceding claims, **characterized in that** the compensating means (17) contain copper and preferably at least portionwise and in particular completely are made essentially from copper.

6. Ceramic substrate according to one of the preceding claims, **characterized in that** the solder layer of the connection between the compensating means (17) and the substrate (11) and in particular also between the compensating means and the connecting means (12) is an active solder layer (22) and in particular the active solder (18, 22) is based on silver and copper with a reactive alloying component with a high oxygen affinity and/or high nitrogen affinity, preferably titanium and/or a rare earth metal.

7. Ceramic substrate according to claim 6, **characterized in that** active solder (18, 22) connects the connection to the compensating means and to the substrate (11) and is in particular applied to a surface area on the substrate at least corresponding to and in particular projecting over the compensating means and preferably forms the electrical connection from the connection to the electrical circuit (24).

8. Ceramic substrate according to claim 6 or 7, **characterized in that** the electrical circuit (24) has a connection field (23), which in one area has a limited spacing from the active solder layer (18, 22), the connection field and active solder layer, separated by a separating gap (25), form a contact zone (26), which is provided with a contact layer overlapping the said two layers and filling the separating gap, said layer (27) being electrically conductive and is preferably a conductive paste with a baking temperature below the melting point of the active solder, and in particular the separating gap is constructed in zig-zag manner or in wavy form for maximum contacting length.

9. Ceramic substrate according to one of the claims 6 to 8, **characterized in that** the height of the active solder layer (18, 22) between the compensating means and the substrate and/or between the connection and the compensating means is in the range 0.01 mm to 4 mm, preferably 0.2 mm to 2 mm.

10. Ceramic substrate according to one of the preceding claims, **characterized in that** between the compensating means and the substrate (11) is provided a matching plate (29) or a matching annular disk (31) and which is in particular made from a material wettable by an active solder (18) and preferably a ceramic or metal.

11. Ceramic substrate according to one of the preceding claims, **characterized in that** the connection is constructed for a mechanical securing of the substrate (11) and an electrical connection for the electrical circuit (24) and preferably, for the mechanical securing, is provided with a thread or the like and in particular it has a larger cross-section base towards the compensating means.

12. Ceramic substrate according to one of the preceding claims, **characterized in that** it is a disk-shaped ceramic hotplate (35) with a planar front for use in an electric cooker, the connecting means (12) and thick film resistance heaters (33) being located on the back (36), and the hotplate is connected by means of several connecting means and also electrically to the cooker control system and is also fixed in mechanically retaining manner to the electric cooker.
